(19) Europäisches Patentamt
European Patent Office
Office européen des brevets

(11) **EP 4 390 344 A1**

(12) **DEMANDE DE BREVET EUROPEEN**

(43) Date de publication:
**26.06.2024 Bulletin 2024/26**

(21) Numéro de dépôt: **23215994.7**

(22) Date de dépôt: **12.12.2023**

(51) Classification Internationale des Brevets (IPC):
**G01J 4/04** (2006.01)    **H01L 27/146** (2006.01)

(52) Classification Coopérative des Brevets (CPC):
**G01J 4/04; H01L 27/14625; H01L 27/14627; H01L 27/1464; H01L 27/14643**

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**
Etats d'extension désignés:
**BA**
Etats de validation désignés:
**KH MA MD TN**

(30) Priorité: **20.12.2022 FR 2213923**

(71) Demandeur: **Commissariat à l'énergie atomique et aux énergies alternatives**
**75015 Paris (FR)**

(72) Inventeurs:
• **DENEUVILLE, François**
**décédé(e) (FR)**
• **VAILLANT, Jérôme**
**38054 GRENOBLE CEDEX 09 (FR)**
• **ABADIE, Quentin**
**38054 GRENOBLE CEDEX 09 (FR)**

(74) Mandataire: **Thibon, Laurent**
**Cabinet Beaumont**
**4, Place Robert Schuman**
**B.P. 1529**
**38025 Grenoble Cedex 1 (FR)**

(54) **CAPTEUR D'IMAGES POLARIMÉTRIQUE**

(57) La présente description concerne un capteur d'images polarimétrique (400) formé dans et sur un substrat semiconducteur, le capteur comprenant :
- une pluralité de pixels (P) comprenant chacun un photodétecteur formé dans le substrat semiconducteur ;
- un routeur de polarisation comprenant une métasurface bidimensionnelle (MS) disposée du côté d'une face d'éclairement des photodétecteurs, la métasurface comprenant un réseau bidimensionnel de plots ; et
- une pluralité de premières microlentilles (401) s'étendant en vis-à-vis d'une paire de pixels adjacents du capteur.

Fig. 4A

EP 4 390 344 A1

## Description

Domaine technique

La présente description concerne de façon générale les capteurs d'images, et vise plus particulièrement des capteurs d'images dits polarimétriques, adaptés à enregistrer des informations relatives à la polarisation de la lumière captée.

Technique antérieure

La mesure de l'information de polarisation de la lumière lors de l'acquisition d'une image peut présenter un intérêt pour de nombreuses applications. Elle permet en particulier la mise en oeuvre de traitements d'amélioration des images, adaptés en fonction de l'application considérée. Par exemple, elle permet d'atténuer ou au contraire d'exacerber des reflets sur une image de toute surface provoquant une réflexion spéculaire, comme une vitre, de l'eau ou la surface d'un oeil. Elle rend en outre possible de détecter des objets manufacturés dans un environnement naturel, ces derniers présentant généralement une signature en polarisation. Parmi les applications pouvant tirer profit de la mesure de l'information de polarisation, on peut également citer des applications de contrôle industriel, des applications biomédicales, par exemple des applications de détection de cellules cancéreuses (ces dernières polarisant la lumière de par leur nature fibreuse), des applications d'amélioration de contraste pour la capture d'images en milieu diffusant (brouillard, imagerie sous-marine, etc.), ou encore des applications de cartographie de distance ou acquisition d'images de profondeur, dans lesquelles la polarisation peut fournir des informations sur l'orientation de la surface des objets manufacturés, et ainsi aider la reconstruction 3D en complément d'une autre modalité comme l'illumination active par lumière structurée ou par mesure de temps de vol.

Pour mesurer l'information de polarisation, il a déjà été proposé d'acquérir successivement, au moyen d'un même capteur, plusieurs images d'une même scène, en plaçant à chaque acquisition un polariseur en vis-à-vis du capteur, et en changeant de polariseur entre deux acquisitions successives. Il en résulte des systèmes d'acquisition relativement volumineux, avec la présence devant le capteur d'un mécanisme, par exemple une roue ou platine rotative motorisée sur laquelle sont fixés les différents polariseurs, permettant de changer le polariseur entre deux acquisitions. Une autre limitation est liée à la nécessité d'acquérir successivement plusieurs images de la scène pour enregistrer plusieurs états de polarisation. Ceci peut notamment poser problème lorsque la scène varie dans le temps.

Pour pallier ces limitations, il a été proposé de placer une matrice de filtres polariseurs en vis-à-vis du capteur d'images. Une limitation reste toutefois que les filtres polariseurs bloquent une partie du signal lumineux reçu par le système d'acquisition. Ainsi, la sensibilité globale ou rendement quantique global du système d'acquisition est relativement faible.

Il serait souhaitable de pallier au moins en partie certaines limitations des solutions connues d'acquisition d'images polarimétriques.

Résumé de l'invention

Pour cela, un mode de réalisation prévoit un capteur d'images polarimétrique formé dans et sur un substrat semiconducteur, le capteur comprenant :

- une pluralité de pixels comprenant chacun un photodétecteur formé dans le substrat semiconducteur ;
- un filtre polariseur disposé du côté d'une face d'éclairement des photodétecteurs, le filtre comprenant, pour chaque pixel, une structure de polarisation ; et
- un routeur de polarisation comprenant une métasurface bidimensionnelle disposée du côté du filtre polariseur opposé aux photodétecteurs, la métasurface comprenant un réseau bidimensionnel de plots.

Selon un mode de réalisation, ladite pluralité de pixels comprend au moins des premier et deuxième pixels adaptés à mesurer des rayonnements selon respectivement des première et deuxième polarisations distinctes, la structure de polarisation du premier pixel étant adaptée à transmettre majoritairement des rayonnements selon la première polarisation et la structure de polarisation du deuxième pixel étant adaptée à transmettre majoritairement des rayonnements selon la deuxième polarisation.

Selon un mode de réalisation, une première partie de la métasurface bidimensionnelle située à l'aplomb des premier et deuxième pixels est adaptée à transmettre majoritairement :

- des rayonnements selon la première polarisation vers la structure de polarisation du premier pixel ; et
- des rayonnements selon la deuxième polarisation vers la structure de polarisation du deuxième pixel.

Selon un mode de réalisation, les première et deuxième polarisations sont des polarisations linéaires selon des première et deuxième directions formant respectivement des angles de 0° et 90° par rapport à une direction de référence.

Selon un mode de réalisation, ladite pluralité de pixels comprend en outre des troisième et quatrième pixels adaptés à mesurer des rayonnements selon respectivement des troisième et quatrième polarisations distinctes, différentes des première et deuxième polarisations, la structure de polarisation du troisième pixel étant adaptée à transmettre majoritairement des rayonnements selon la troisième polarisation et la structure de polarisation du quatrième pixel étant adaptée à transmettre majoritairement des rayonnements selon la quatrième polarisation.

Selon un mode de réalisation, une deuxième partie de la métasurface bidimensionnelle, différente de la première partie et située à l'aplomb des troisième et quatrième pixels, est adaptée à transmettre majoritairement :

- des rayonnements selon la troisième polarisation vers la structure de polarisation du troisième pixel ; et
- des rayonnements selon la quatrième polarisation vers la structure de polarisation du quatrième pixel.

Selon un mode de réalisation, les troisième et quatrième polarisations sont des polarisations linéaires selon des troisième et quatrième directions formant respectivement des angles de 45° et 135° par rapport à la direction de référence.

Selon un mode de réalisation, chaque structure de polarisation comprend une pluralité de barres parallèles métalliques.

Selon un mode de réalisation, chaque barre métallique est revêtue d'un empilement absorbant.

Selon un mode de réalisation, l'empilement absorbant comprend :

- une couche de tungstène ;
- une couche de silicium, revêtant la couche de tungstène ; et
- une couche diélectrique, revêtant la couche de silicium.

Selon un mode de réalisation, les plots de la métasurface bidimensionnelle sont en silicium amorphe.

Selon un mode de réalisation, les plots de la métasurface bidimensionnelle sont entourés latéralement d'oxyde de silicium.

Selon un mode de réalisation, les plots de la métasurface bidimensionnelle présentent des dimensions latérales sub-longueur d'onde.

Selon un mode de réalisation, le capteur comprend en outre une pluralité de premières microlentilles s'étendant en vis-à-vis d'une paire de pixels adjacents du capteur.

Selon un mode de réalisation, les premières microlentilles présentent chacune une forme allongée.

Selon un mode de réalisation, les premières microlentilles sont :

A) disposées du côté d'une face de la métasurface bidimensionnelle opposée aux photodétecteurs ; ou
B) interposées entre les photodétecteurs et la métasurface bidimensionnelle.

Selon un mode de réalisation, le capteur comprend en outre une pluralité de deuxièmes microlentilles distinctes des premières microlentilles et disposées du côté d'une face de la métasurface bidimensionnelle opposée aux photodétecteurs, chaque deuxième microlentille s'étendant en vis-à-vis d'une paire de pixels adjacents du capteur.

Selon un mode de réalisation, chaque deuxième microlentille présente une forme allongée.

Selon un mode de réalisation, chaque première microlentille s'étend en outre en vis-à-vis de la première partie ou de la deuxième partie de la métasurface.

Par ailleurs, un mode de réalisation prévoit un capteur d'images polarimétrique formé dans et sur un substrat semiconducteur, le capteur comprenant :

- une pluralité de pixels comprenant chacun un photodétecteur formé dans le substrat semiconducteur ;
- un routeur de polarisation comprenant une métasurface bidimensionnelle disposée du côté d'une face d'éclairement des photodétecteurs, la métasurface comprenant un réseau bidimensionnel de plots ; et
- une pluralité de premières microlentilles s'étendant en vis-à-vis d'une paire de pixels adjacents du capteur.

Selon un mode de réalisation, les premières microlentilles sont disposées du côté du routeur de polarisation opposé aux photodétecteurs.

Selon un mode de réalisation, les premières microlentilles sont interposées entre les photodétecteurs et la métasurface bidimensionnelle.

Selon un mode de réalisation, ladite pluralité de pixels comprend, en vis-à-vis de l'une des premières microlentilles, des premier et deuxième pixels adaptés à mesurer des rayonnements selon respectivement des première et deuxième polarisations distinctes, une première partie de la métasurface bidimensionnelle située à l'aplomb des premier et deuxième pixels étant adaptée à transmettre majoritairement :

- des rayonnements selon la première polarisation vers le premier pixel ; et
- des rayonnements selon la deuxième polarisation vers le deuxième pixel.

Selon un mode de réalisation, les rangées de plots de la première partie de la métasurface bidimensionnelle sont identiques entre elles.

Selon un mode de réalisation, la première partie de la métasurface bidimensionnelle est adaptée à focaliser les rayonnements incidents majoritairement le long d'une direction parallèle aux rangées de plots.

Selon un mode de réalisation, ladite pluralité de pixels comprend en outre des troisième et quatrième pixels adaptés à mesurer des rayonnements selon respectivement des troisième et quatrième polarisations distinctes, différentes des première et deuxième polarisations, une deuxième partie de la métasurface bidimensionnelle située à l'aplomb des troisième et quatrième pixels étant adaptée à transmettre majoritairement :

- des rayonnements selon la troisième polarisation

- vers le troisième pixel ; et
- des rayonnements selon la quatrième polarisation vers le quatrième pixel.

Selon un mode de réalisation, le capteur comprend en outre un filtre polariseur interposé entre ladite pluralité de pixels et la métasurface bidimensionnelle, le filtre comprenant, pour chaque pixel, une structure de polarisation.

Selon un mode de réalisation, la structure de polarisation du premier pixel est adaptée à transmettre majoritairement des rayonnements selon la première polarisation et la structure de polarisation du deuxième pixel est adaptée à transmettre majoritairement des rayonnements selon la deuxième polarisation.

Par ailleurs, un mode de réalisation prévoit un filtre polariseur destiné à être disposé en vis-à-vis d'un capteur d'images comprenant une pluralité de pixels, le filtre comprenant, pour chaque pixel, une structure de polarisation comportant une pluralité de barres métalliques parallèles, chaque barre étant revêtue d'un empilement absorbant comprenant :

- une couche de tungstène ;
- une couche de silicium, revêtant la couche de tungstène ; et
- une couche diélectrique, revêtant la couche de silicium.

Selon un mode de réalisation, les barres métalliques sont en un matériau différent du tungstène, de préférence en aluminium.

Selon un mode de réalisation, la couche de tungstène présente une épaisseur supérieure à 40 nm, de préférence supérieure à 60 nm.

Selon un mode de réalisation, les barres métalliques sont en tungstène.

Selon un mode de réalisation, les barres métalliques et la couche de tungstène présentent une épaisseur cumulée supérieure à 40 nm, de préférence supérieure à 60 nm.

Selon un mode de réalisation, la couche de silicium présente une épaisseur comprise entre 20 et 100 nm, de préférence entre 30 et 50 nm, par exemple égale à environ 39 nm.

Selon un mode de réalisation, la couche diélectrique est en oxyde de silicium.

Selon un mode de réalisation, la couche diélectrique est constituée d'un empilement de plusieurs couches en des matériaux diélectriques d'indices de réfraction inférieurs à celui du silicium.

Par ailleurs, un mode de réalisation prévoit un capteur d'images polarimétrique formé dans et sur un substrat semiconducteur, le capteur comprenant :

- une pluralité de pixels comprenant chacun un photodétecteur formé dans le substrat semiconducteur ; et

- un filtre polariseur tel que décrit, le filtre étant disposé du côté d'une face d'éclairement des photodétecteurs.

Selon un mode de réalisation, les première, deuxième, troisième et quatrième polarisations sont des polarisations linéaires selon des première, deuxième, troisième et quatrième directions formant respectivement des angles de 0°, 90°, 45° et 135° par rapport à une direction de référence.

Selon un mode de réalisation, le capteur comporte en outre un routeur de polarisation comprenant une métasurface bidimensionnelle disposée du côté du filtre polariseur opposé aux photodétecteurs, la métasurface comprenant un réseau bidimensionnel de plots.

Selon un mode de réalisation, la métasurface bidimensionnelle comprend :

- une première partie située à l'aplomb des premier et deuxième pixels adaptée à transmettre majoritairement :

  des rayonnements selon la première polarisation vers le premier pixel ; et
  des rayonnements selon la deuxième polarisation vers le deuxième pixel, et

- une deuxième partie située à l'aplomb des troisième et quatrième pixels adaptée à transmettre majoritairement :

  des rayonnements selon la troisième polarisation vers le troisième pixel ; et
  des rayonnements selon la quatrième polarisation vers le quatrième pixel.

<u>Brève description des dessins</u>

Ces caractéristiques et avantages, ainsi que d'autres, seront exposés en détail dans la description suivante de modes de réalisation particuliers faite à titre non limitatif en relation avec les figures jointes parmi lesquelles :

  la figure 1A et la figure 1B sont respectivement une vue en perspective éclatée et une vue en coupe d'un exemple d'un capteur d'images polarimétrique selon un mode de réalisation ;

  la figure 2 est une vue de dessus, schématique et partielle, d'un exemple de réalisation du filtre polariseur du capteur des figures 1A et 1B ;

  la figure 3 est une vue de dessus, schématique et partielle, d'un exemple de réalisation du routeur de polarisation du capteur des figures 1A et 1B ;

  la figure 4A et la figure 4B sont respectivement une vue en perspective éclatée et une vue en coupe d'un autre exemple d'un capteur d'images polarimétrique selon un mode de réalisation ;

la figure 5 est une vue de dessus, schématique et partielle, d'un exemple de réalisation du routeur de polarisation du capteur des figures 4A et 4B ;

la figure 6A et la figure 6B sont respectivement une vue en perspective éclatée et une vue en coupe d'un autre exemple d'un capteur d'images polarimétrique selon un mode de réalisation ;

la figure 7 est une vue en coupe, schématique et partielle, du filtre polariseur du capteur des figures 6A et 6B ;

la figure 8 est une vue en coupe d'un autre exemple d'un capteur d'images polarimétrique selon un mode de réalisation ; et

la figure 9 une vue en coupe d'un autre exemple d'un capteur d'images polarimétrique selon un mode de réalisation.

Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, les éléments de photo-détection et les circuits électroniques de contrôle des capteurs d'images décrits n'ont pas été détaillés, les modes de réalisation décrits étant compatibles avec les réalisations usuelles de ces éléments. En outre, les applications que peuvent avoir les capteurs d'images décrits n'ont pas été détaillées, les modes de réalisation décrits étant compatibles avec toutes ou la plupart des applications connues des systèmes d'acquisition d'images polarimétriques.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais « coupled ») entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes « avant », « arrière », « haut », « bas », « gauche », « droite », etc., ou relative, tels que les termes « dessus », « dessous », « supérieur », « inférieur », etc., ou à des qualificatifs d'orientation, tels que les termes « horizontal », « vertical », etc., il est fait référence, sauf précision contraire, à l'orientation des figures.

Sauf précision contraire, les expressions « environ », « approximativement », « sensiblement », et « de l'ordre de » signifient à 10 % près, de préférence à 5 % près, ou, lorsqu'il s'agit de valeurs angulaires, à 10° près, de préférence à 5° près.

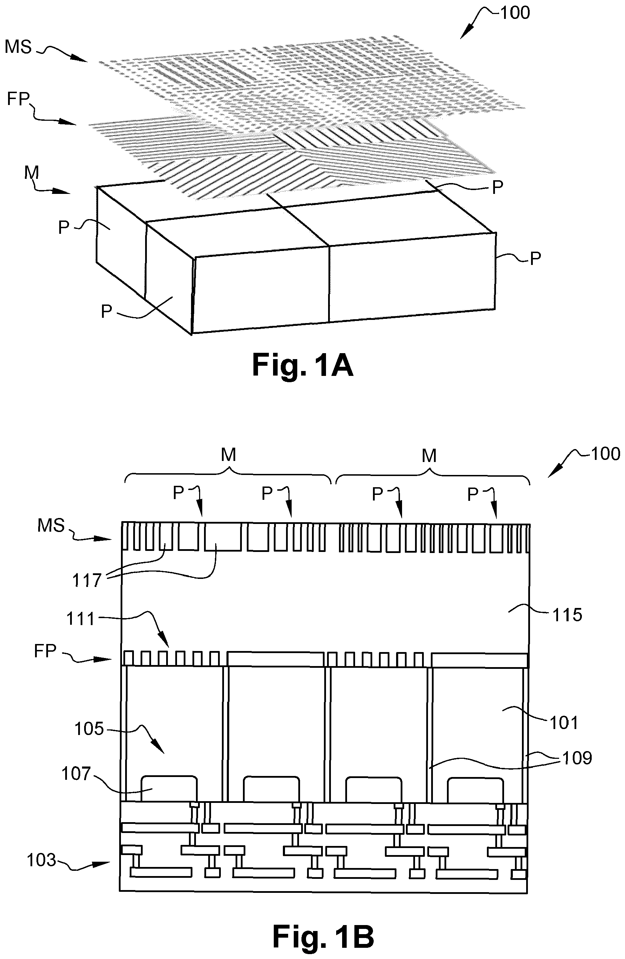

La figure 1A et la figure 1B sont respectivement une vue en perspective éclatée et une vue en coupe d'un exemple d'un capteur d'images polarimétrique 100 selon un mode de réalisation.

Le capteur 100 est formé dans et sur un substrat 101. Le substrat 101 est par exemple en un matériau semiconducteur monocristallin, par exemple en silicium monocristallin.

Le capteur 100 comprend une pluralité de pixels P formés dans et sur le substrat semiconducteur 101. En vue de dessus, les pixels P sont par exemple agencés en matrice selon des rangées et des colonnes.

Le capteur 100 comprend en outre, du côté d'une première face du substrat 101, appelée face avant, correspondant à la face inférieure du substrat 101 dans l'orientation des figures 1A et 1B, un empilement 103 de couches isolantes et conductrices (par exemple métalliques), appelé empilement d'interconnexion, dans lequel sont formés des éléments d'interconnexion (par exemple des pistes et vias conducteurs d'interconnexion) des pixels P du capteur.

Dans l'exemple des figures 1A et 1B, le capteur 100 est un capteur à éclairement par la face arrière, aussi appelé capteur BSI (de l'anglais « Back Side Illumination »), c'est-à-dire que les rayons lumineux en provenance de la scène à imager éclairent le substrat 101 par sa face arrière, c'est-à-dire sa face opposée à l'empilement d'interconnexion 103, à savoir sa face supérieure dans l'orientation des figures 1A et 1B.

Chaque pixel P du capteur 100 comprend une région photosensible 105 formée dans le substrat 101. Chaque région photosensible 105 comprend par exemple un élément de photo-détection 107, par exemple une photodiode ou photodétecteur. Dans l'exemple représenté, les régions photosensibles 105 des pixels P sont séparées latéralement les unes des autres par des murs d'isolation 109. Les murs d'isolation 109 sont par exemple en un matériau diélectrique, par exemple de l'oxyde de silicium. À titre de variante (non détaillée sur les figures), les murs d'isolation 109 comprennent des parois latérales externes en un matériau diélectrique, par exemple de l'oxyde de silicium, et une paroi centrale en un matériau électriquement conducteur, par exemple du silicium polycristallin dopé ou un métal. Dans cet exemple, les murs d'isolation 109 s'étendent verticalement à travers toute l'épaisseur du substrat 101. L'épaisseur du substrat 101 est par exemple comprise entre 1 et 20 $\mu$m, par exemple entre 3 et 10 $\mu$m. À titre de variante, les murs d'isolation 109 peuvent être omis.

Chaque pixel P est surmonté d'une structure de polarisation 111 disposée en vis-à-vis de la région photosensible 105 du pixel, du côté de la face d'éclairement du photodétecteur 107, c'est-à-dire du côté de la face supérieure du substrat 101 dans l'orientation des figures 1A et 1B. L'ensemble des structures de polarisation 111 situées à l'aplomb des pixels P du capteur 100 forme par exemple un filtre de polarisation ou filtre polariseur FP.

Chaque structure de polarisation 111 est adaptée à transmettre majoritairement des rayonnements lumineux selon une polarisation prédéfinie.

Dans l'exemple des figures 1A et 1B, le capteur comprend plusieurs pixels P dont les structures de polarisation 111 respectives présentent des orientations de polarisation différentes et sont ainsi adaptées à transmettre majoritairement des rayons lumineux selon des polarisations différentes. Ceci permet de mesurer, au moyen de pixels P distincts, des intensités de rayonnements lumineux reçus selon des polarisations différentes. Autrement dit, le capteur comprend au moins des premier et deuxième pixels P destinés à mesurer des intensités de rayonnements lumineux reçus selon respectivement des première et deuxième polarisations, par exemple des première et deuxième polarisations linéaires orthogonales. À titre d'exemple, la structure de polarisation 111 du premier pixel présente un coefficient de transmission des rayonnements selon la première polarisation supérieur à son coefficient de transmission des rayonnements selon la deuxième polarisation, et la structure de polarisation 111 du deuxième pixel présente un coefficient de transmission des rayonnements selon la deuxième polarisation supérieur à son coefficient de transmission des rayonnements selon la première polarisation.

Les structures de polarisation sont par exemple des structures métalliques comprenant des ouvertures et transmettant majoritairement les rayonnements selon une polarisation prédéfinie, et absorbant ou réfléchissant les rayonnements selon les autres polarisations. Les structures métalliques sont par exemple en aluminium ou en cuivre. À titre de variante, d'autres métaux peuvent être utilisés, par exemple l'argent, l'or, le tungstène ou le titane.

À titre d'exemple, un matériau de remplissage 115, par exemple un matériau diélectrique, par exemple de l'oxyde de silicium, du nitrure de silicium, de l'alumine ($Al_2O_3$), de l'oxyde de tantale ou de l'oxyde d'hafnium, remplit les ouvertures formées dans les structures métalliques. Dans cet exemple, le matériau 115 recouvre en outre les structures de polarisation 111, formant une couche de planarisation 115. À titre de variante, les ouvertures des structures de polarisation 111 peuvent être laissées vides ou remplies d'air.

En pratique, le choix des motifs et le dimensionnement des structures de polarisation 111 peut être réalisé au moyen d'outils connus de simulation électromagnétiques.

À titre d'exemple, les pixels P sont répartis en macropixels M comprenant chacun au moins deux pixels P adjacents, par exemple quatre pixels P adjacents. Dans chaque macropixel M, les pixels P du macropixel ont des structures de polarisation 111 différentes. Ainsi, dans chaque macropixel M, les pixels P du macropixel mesurent des intensités de rayonnements lumineux reçus selon des polarisations différentes.

Le capteur 100 comprend en outre une métasurface bidimensionnelle (2D) MS située en vis-à-vis des pixels P. La métasurface MS est plus précisément disposée du côté du filtre polariseur FP opposé aux photodétecteurs 107. La métasurface MS comprend un réseau bidimensionnel de plots 117 d'un premier matériau, par exemple le silicium amorphe, entourés latéralement par un deuxième matériau, par exemple le matériau 115, par exemple l'oxyde de silicium. De manière plus générale, le premier matériau présente un indice de réfraction supérieur à celui du deuxième matériau. Les plots 117 de la métasurface MS présentent des dimensions latérales sub-longueur d'onde, c'est-à-dire que la plus grande dimension latérale de chaque plot 117 est inférieure à la longueur d'onde principale destinée à être mesurée par le pixel P sous-jacent, c'est-à-dire la longueur d'onde pour laquelle le rendement quantique du pixel P est maximal. Par exemple, pour des pixels P destinés à mesurer des rayonnements visibles ou proche infrarouge, par exemple des rayonnements de longueur d'onde inférieure à 1 μm, la plus grande dimension de chaque plot 117 est comprise entre 10 et 500 nm, par exemple entre 30 et 300 nm.

La métasurface MS correspond par exemple à un routeur ou trieur de polarisation adapté à mettre en oeuvre une fonction optique de routage ou tri de polarisation vers les différentes structures de polarisation 111 sous-jacentes du filtre polariseur FP. En pratique, la métasurface MS comprend, en vis-à-vis de chaque pixel P, une pluralité de plots 117 de dimensions latérales variées. Le dimensionnement et la disposition des plots 117 sont définis en fonction de la fonction optique que l'on cherche à réaliser. Par exemple, pour réaliser la fonction de routage de polarisation ou routage de lumière polarisée, on peut prévoir des plots 117 présentant, en vue de dessus, des formes asymétriques, par exemple rectangulaires ou elliptiques, étant entendu que les plots 117 peuvent présenter, en vue de dessus, une forme quelconque. Les plots 117 peuvent présenter des flancs verticaux, c'est-à-dire orthogonaux à la face supérieure du substrat 101, des flancs obliques ou des flancs en forme d'escalier, comprenant au moins une marche. Par ailleurs, chaque plot 117 peut être constitué d'un matériau unique ou d'un empilement de couches de matériaux différents. Le motif de la métasurface MS peut être défini au moyen d'un outil de simulation électromagnétique, par exemple en utilisant des méthodes de conception inverse, par exemple du type décrit dans l'article intitulé « Phase-to-pattern inverse design paradigm for fast realization of functional metasurfaces via transfer learning » de Zhu, R., Qiu, T., Wang, J. et al. Nat. Commun. 12, 2974 (2021), ou dans l'article intitulé « Matrix Fourier optics enables a compact full-Stokes polarization caméra » de Rubin et al. (SCIENCE - Volume 365 - Issue 6448 - 5 July 2019) .

Les plots 117 de la métasurface MS ont de préférence tous la même hauteur, par exemple du même ordre de grandeur que la longueur d'onde principale destinée à être mesurée par chaque pixel P, par exemple comprise entre 20 nm et 2 $\mu$m, de préférence entre 50 nm et 750 nm, pour des rayonnements de longueur d'onde inférieure à 1 $\mu$m. Le fait de prévoir des plots 117 de hauteur constante sur toute la surface du capteur permet avantageusement de simplifier la fabrication de la métasurface MS.

Dans l'exemple illustré en figures 1A et 1B, le trieur de polarisation du capteur 100 comprend une seule métasurface MS. À titre de variante, le trieur de polarisation du capteur 100 pourrait comprendre plusieurs métasurfaces, par exemple analogues à la métasurface MS.

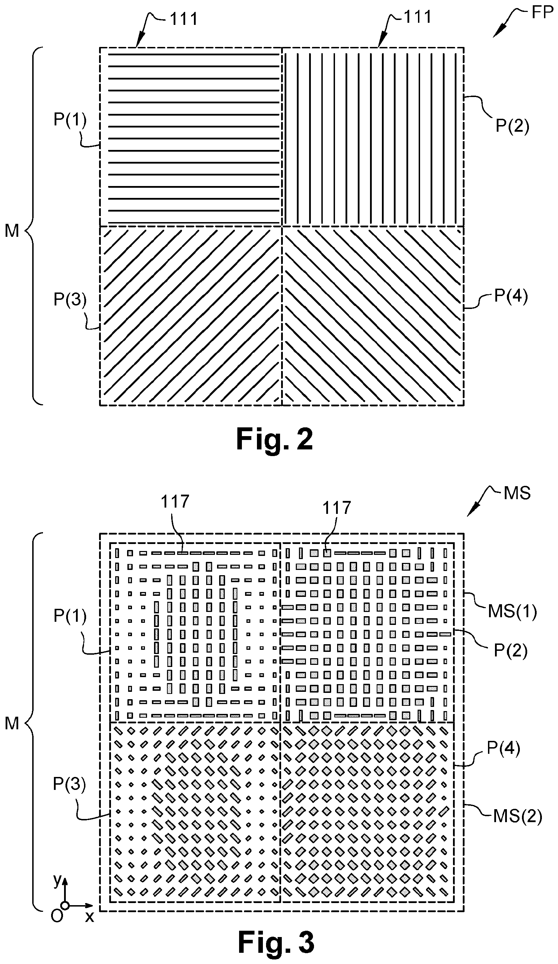

La figure 2 est une vue de dessus, schématique et partielle, d'un exemple de réalisation du filtre polariseur FP du capteur 100 des figures 1A et 1B.

La figure 2 illustre plus particulièrement les structures de polarisation 111 des pixels P d'un même macropixel M. Dans cet exemple, chaque macropixel M comprend quatre pixels P(1), P(2), P(3) et P(4) adjacents adaptés à mesurer des intensités de rayonnement lumineux reçus selon respectivement quatre orientations de polarisation PS1, PS2, PS3 et PS4 différentes, par exemple des polarisations linéaires selon respectivement quatre directions formant respectivement des angles de 0°, 90°, 45° et 135° par rapport à une direction de référence. Dans cet exemple les quatre pixels P(1), P(2), P(3) et P(4), symbolisés par des carrés en pointillé en figure 2, sont agencés en matrice selon deux lignes et deux colonnes.

Les structures de polarisation 111 sont par exemple des grilles métalliques comprenant chacune une pluralité de barres métalliques parallèles régulièrement espacées, transmettant majoritairement les rayonnements selon une polarisation linéaire perpendiculaire aux barres métalliques, et absorbant les rayonnements selon les autres polarisations.

À titre de variante, le nombre de pixels P par macropixel M peut être différent de quatre. De plus, les modes de réalisation décrits ne se limitent pas à des structures de polarisation 111 linéaires. À titre de variante, chaque macropixel M peut comprendre une ou plusieurs structures de polarisation 111 linéaires et/ou une ou plusieurs structures de polarisation 111 circulaires.

À titre d'exemple, les structures de polarisation 111 des pixels P de même position dans les différents macropixels M du capteur sont adaptées à transmettre majoritairement la même orientation de polarisation.

À titre d'exemple, les structures de polarisation 111 de même orientation de polarisation dans les différents macropixels M du capteur sont toutes identiques, aux dispersions de fabrication près.

À titre de variante, les structures de polarisation 111 de même orientation de polarisation dans les différents macropixels M du capteur présentent des motifs adaptés en fonction de la position du macropixel M sur le capteur, pour tenir compte de la direction d'incidence principale des rayons lumineux reçus par le macropixel.

Bien que cela n'ait pas été illustré en figures 1A et 1B, chaque pixel P du capteur 100 peut comprendre un filtre couleur disposé au-dessus de la structure de polarisation et adapté à transmettre la lumière majoritairement dans une gamme de longueurs d'ondes déterminée. Les filtres couleur sont par exemple disposés au-dessus de la couche de planarisation 115, par exemple en contact, par leur face inférieure, avec la face supérieure de la couche 115. Des pixels P différents peuvent comprendre des filtres couleur différents. À titre d'exemple, le capteur comprend des pixels P comprenant un filtre couleur adapté à transmettre majoritairement de la lumière rouge, des pixels P comprenant un filtre couleur adapté à transmettre majoritairement de la lumière verte, et des pixels P comprenant un filtre couleur adapté à transmettre majoritairement de la lumière bleue. À titre d'exemple, les pixels P d'un même macropixel M comprennent des filtres couleurs identiques, et les pixels P de macropixels M voisins comprennent des filtres couleurs différents. Les filtres couleur sont par exemple en résine colorée.

À titre d'exemple, les structures de polarisation 111 de même orientation de polarisation dans les différents macropixels M du capteur présentent des motifs adaptés en fonction de la couleur du pixel, c'est-à-dire de la gamme de longueurs d'ondes transmise majoritairement par le filtre couleur du pixel.

À titre d'exemple, non limitatif, pour des polariseurs linéaires du type illustré en figure 2, réalisés en aluminium avec un remplissage en oxyde de silicium, et destinés à fonctionner à des longueurs d'onde visible et/ou infrarouge, le dimensionnement des barres métalliques peut être comme suit :

- pour de la lumière bleue de longueur d'onde de l'ordre de 450 nm (et/ou pour de la lumière de longueur d'onde supérieure, par exemple de la lumière infrarouge), les barres métalliques peuvent présenter une hauteur comprise entre 50 et 100 nm, une largeur de l'ordre de 60 nm et une période de répétition de l'ordre de 180 nm ;
- pour de la lumière verte de longueur d'onde de l'ordre de 530 nm (et/ou pour de la lumière de longueur d'onde supérieure, par exemple de la lumière infrarouge), les barres métalliques peuvent présenter une hauteur comprise entre 50 et 100 nm, une largeur de l'ordre de 70 nm et une période de répétition de l'ordre de 210 nm ;
- pour de la lumière rouge de longueur d'onde de l'ordre de 610 nm (et/ou pour de la lumière de longueur d'onde supérieure, par exemple de la lumière infrarouge), les barres métalliques peuvent présenter une hauteur comprise entre 50 et 100 nm, une largeur de l'ordre de 80 nm et une période de répétition de l'ordre de 240 nm ; et

- pour de la lumière infrarouge de longueur d'onde de l'ordre de 940 nm ou supérieure, les barres métalliques peuvent présenter une hauteur comprise entre 50 et 100 nm, une largeur de l'ordre de 90 nm et une période de répétition de l'ordre de 280 nm.

En pratique, pour des questions de simplification des procédés de fabrication, il est préférable que la hauteur des barres métalliques des structures de polarisation 111 soit la même dans tous les pixels P du capteur. Ainsi, des compromis peuvent être réalisés entre la complexité de réalisation des polariseurs 111 et leurs performances de filtrage de polarisation.

La figure 3 est une vue de dessus, schématique et partielle, d'un exemple de réalisation du routeur de polarisation du capteur des figures 1A et 1B.

La figure 3 illustre plus particulièrement un exemple de forme et de disposition des plots 117 de la métasurface MS à l'aplomb d'un macropixel M. Dans cet exemple, le macropixel M comprend, comme exposé précédemment en relation avec la figure 2, les quatre pixels P(1), P(2), P(3) et P(4) adjacents adaptés à mesurer des intensités de rayonnement lumineux reçus selon respectivement les quatre orientations de polarisation PS1, PS2, PS3 et PS4 différentes.

Dans l'exemple représenté, la métasurface MS comprend une première partie MS(1), située à l'aplomb des pixels P(1) et P(2), et une deuxième partie MS(2), située à l'aplomb des pixels P(3) et P(4). Dans cet exemple, la première partie MS(1) de la métasurface MS présente un motif adapté à mettre en oeuvre une fonction de routage des rayons lumineux reçus selon les deux états de polarisation PS1 et PS2 vers respectivement les structures de polarisation 111 des deux pixels P(1) et P(2) du macropixel M. De façon analogue, la deuxième partie MS(2) de la métasurface MS présente un motif adapté à mettre en oeuvre une fonction de routage des rayons lumineux reçus selon les deux états de polarisation PS3 et PS4 vers respectivement les structures de polarisation 111 des deux pixels P(3) et P(4) du macropixel M. Les composantes du flux incident polarisées selon les états PS1, PS2, PS3 et PS4 sont ainsi déviées vers respectivement les pixels P(1), P(2), P(3) et P(4) du macropixel M. Un photon arrivant au-dessus du pixel P(1) ou du pixel P(2) sera alors trié en PS1 ou PS2, et un photon arrivant au-dessus du pixel P(3) ou du pixel P(4) sera trié en PS3 ou PS4.

Par rapport à un capteur polarimétrique à base de filtres polariseurs, ceci permet avantageusement d'améliorer le rendement quantique du capteur dans la mesure où la totalité du flux collecté en vis-à-vis de chaque macropixel M est transmis vers les quatre pixels P(1), P(2), P(3) et P(4) du macropixel.

Dans l'exemple représenté, chaque partie MS(1), MS(2) de la métasurface MS est adaptée à focaliser la lumière incidente selon deux axes Ox et Oy orthogonaux, les axes Ox et Oy correspondant respectivement à l'axe horizontal et à l'axe vertical, dans l'orientation de la figure 3.

Les plots 117 présentent par exemple un pas constant, c'est-à-dire une distance centre à centre constante, sur toute la métasurface MS. À titre d'exemple, le pas de la matrice de plots 117 de la métasurface MS est compris entre 250 et 300 nm. Dans l'exemple représenté, les parties MS(1) et MS(2) de la métasurface MS présentent chacune un pourtour de forme sensiblement rectangulaire. Cela correspond par exemple à un cas où les pixels P du capteur présentent chacun, en vue de dessus, un pourtour de forme sensiblement carrée, le rectangle formé par chaque partie MS(1), MS(2) de la métasurface MS présentant par exemple alors des dimensions latérales sensiblement égales à celles d'un rectangle formé par une paire de pixels P adjacents. À titre d'exemple, chaque partie MS(1), MS(2) de la métasurface MS présente une longueur comprise entre 4 et 8 μm et une largeur égale à environ la moitié de la longueur, par exemple comprise entre 2 et 4 μm. Cet exemple n'est toutefois pas limitatif, les parties MS(1) et MS(2) de la métasurface MS pouvant par exemple présenter des dimensions latérales inférieures à celles mentionnées ci-dessus, par exemple inférieures à 1 μm dans un cas où les pixels P présentent un pas de l'ordre de 0,5 μm ou de 1 μm.

À titre de variante, chaque partie MS(1), MS(2) de la métasurface MS peut présenter un pourtour de forme quelconque, par exemple carrée. Cela correspond par exemple à un cas où les pixels P du capteur présentent chacun, en vue de dessus, un pourtour de forme sensiblement rectangulaire, le carré formé par chaque partie MS(1), MS(2) de la métasurface présentant par exemple alors des dimensions latérales sensiblement égales à celles d'un carré formé par une paire de pixels P adjacents par leur grand côté. Un avantage lié au fait de prévoir que chaque partie MS(1), MS(2) de la métasurface MS présente une forme carrée est que cela permet de faciliter un échantillonnage spatial de l'image acquise par les pixels P du capteur 100.

Le motif de la portion de la métasurface MS située à l'aplomb du macropixel M peut être répété à l'identique (aux dispersions de fabrication près) en vis-à-vis de tous les autres macropixels M du capteur.

À titre de variante, le motif de la portion de la métasurface MS peut varier d'un macropixel M à l'autre, en fonction de la position du macropixel sur le capteur, pour tenir compte notamment de la direction principale d'incidence des rayons arrivant sur la métasurface MS en provenance de la scène à imager.

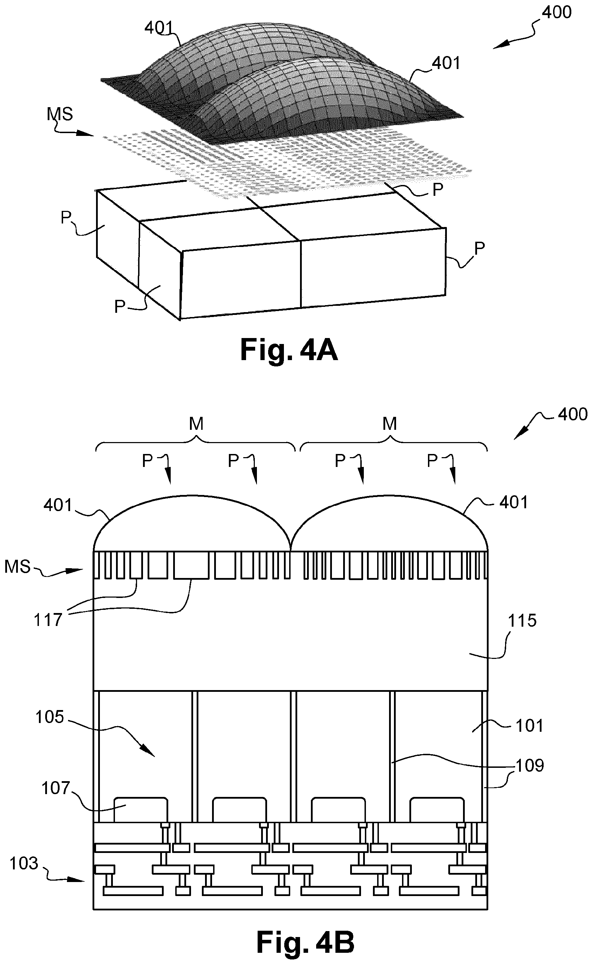

La figure 4A et la figure 4B sont respectivement une vue en perspective éclatée et une vue en coupe d'un autre exemple d'un capteur d'images polarimétrique 400 selon un mode de réalisation.

Le capteur d'images polarimétrique 400 des figures 4A et 4B comprend des éléments communs avec le capteur d'images polarimétrique 100 des figures 1A et 1B. Ces éléments communs ne seront pas détaillés à nouveau ci-après.

Le capteur 400 des figures 4A et 4B diffère du capteur 100 des figures 1A et 1B en ce que le capteur 400 est dépourvu du filtre polariseur FP et comprend, du côté du routeur de polarisation opposé aux photodétecteurs 107, une pluralité de microlentilles 401. Dans l'exemple représenté, chaque microlentille 401 présente une forme allongée et s'étendant en vis-à-vis d'une paire de pixels P adjacents du capteur 400. Chaque microlentille 401 présente par exemple, en vue de dessus, une section de forme ovale ou rectangulaire à coins arrondis. Cela correspond par exemple à un cas où les pixels P du capteur présentent chacun, en vue de dessus, un pourtour de forme sensiblement carrée, chaque microlentille 401 présentant par exemple alors des dimensions latérales égales à celles d'un rectangle formé par une paire de pixels P adjacents. Dans l'exemple représenté, les microlentilles 401 sont des microlentilles réfractives.

À titre de variante, chaque microlentille 401 peut présenter une forme quelconque, par exemple un pourtour de forme circulaire ou de forme carrée à coins arrondis, en vue de dessus. Cela correspond par exemple à un cas où les pixels P du capteur présentent chacun, en vue de dessus, un pourtour de forme sensiblement rectangulaire, le cercle ou le carré formé par le pourtour de chaque microlentille 401 présentant par exemple alors respectivement un diamètre ou un côté sensiblement égal au côté d'un carré formé par une paire de pixels P adjacents par leur grand côté.

À titre d'exemple, chaque microlentille 401 est réalisée en résine fluée.

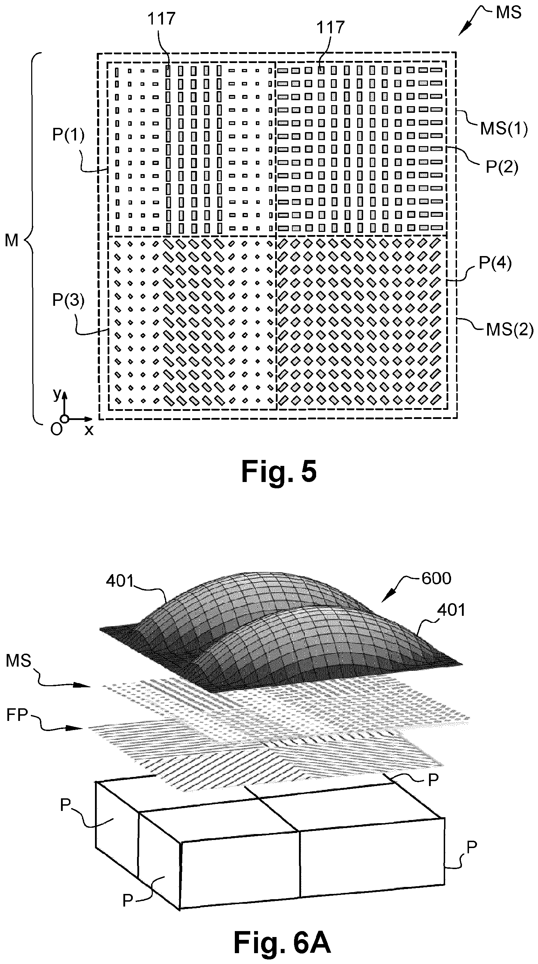

La figure 5 est une vue de dessus, schématique et partielle, d'un exemple de réalisation du routeur de polarisation du capteur 400 des figures 4A et 4B.

La figure 5 illustre plus particulièrement un exemple de forme et de disposition des plots 117 de la métasurface MS du capteur 400 à l'aplomb d'un macropixel M. Dans cet exemple, le macropixel M comprend, comme exposé précédemment en relation avec la figure 2, les quatre pixels P(1), P(2), P(3) et P(4) adjacents adaptés à mesurer des intensités de rayonnement lumineux reçus selon respectivement les quatre orientations de polarisation PS1, PS2, PS3 et PS4 différentes.

Dans l'exemple représenté, la métasurface MS comprend, comme exposé précédemment en relation avec la figure 3, la première partie MS(1) située à l'aplomb des pixels P(1) et P(2), et la deuxième partie MS(2) située à l'aplomb des pixels P (3) et P (4) . Dans cet exemple, la première partie MS(1) de la métasurface MS présente un motif adapté à mettre en oeuvre une fonction de routage des rayons lumineux reçus selon les deux états de polarisation PS1 et PS2 vers respectivement les deux pixels P(1) et P(2) du macropixel M. De façon analogue, la deuxième partie MS(2) de la métasurface MS présente un motif adapté à mettre en oeuvre une fonction de routage des rayons lumineux reçus selon les deux états de polarisation PS3 et PS4 vers respectivement les deux pixels P(3) et P(4) du macropixel M. Les composantes du flux incident polarisées selon les états PS1, PS2, PS3 et PS4 sont ainsi déviées vers respectivement les pixels P(1), P(2), P(3) et P(4) du macropixel M. Un photon arrivant au-dessus du pixel P(1) ou du pixel P(2) sera alors trié en PS1 ou PS2, et un photon arrivant au-dessus du pixel P(3) ou du pixel P(4) sera trié en PS3 ou PS4.

Dans l'exemple représenté, les lignes de plots 117 de la partie MS(1) de la métasurface MS sont identiques les unes aux autres. De façon analogue, les lignes de plots 117 de la partie MS(2) de la métasurface MS sont identiques les unes aux autres.

Dans l'exemple représenté, chaque microlentille 401 s'étend au-dessus d'une partie MS(1) ou MS(2) de la métasurface MS et est adaptée à focaliser la lumière incidente selon les axes orthogonaux Ox et Oy (l'axe horizontal et l'axe vertical, dans l'orientation de la figure 5) sur la partie MS(1) ou MS(2) sous-jacente de la métasurface MS. À titre d'exemple, chaque microlentille 401 présente de l'astigmatisme et présente plus particulièrement une focale selon l'axe Oy strictement inférieure à la focale selon l'axe Ox. Cela correspond par exemple à un cas où les pixels P du capteur présentent chacun, en vue de dessus, un pourtour de forme sensiblement carrée. À titre de variante, chaque microlentille 401 ne présente pas d'astigmatisme. Cela correspond par exemple à un cas où les pixels P du capteur présentent chacun, en vue de dessus, un pourtour de forme sensiblement rectangulaire, chaque microlentille 401 présentant un pourtour de forme sensiblement circulaire. À titre d'exemple, chaque microlentille 401 présente une focale selon l'axe Oy de l'ordre de la distance séparant la microlentille de la face supérieure du substrat 101 (la face du substrat 101 opposée à l'empilement d'interconnexion 103). Par ailleurs, dans cet exemple, chaque partie MS(1), MS(2) de la métasurface MS est adaptée à focaliser majoritairement, voire exclusivement, la lumière incidente selon un axe parallèle aux rangées de plots 117, ici l'axe Ox. Ainsi, dans cet exemple, la focalisation est réalisée conjointement par les microlentilles 401 et par la métasurface MS.

Cela permet de simplifier la conception et la réalisation de la métasurface MS du capteur 400 par rapport à la métasurface MS du capteur 100. À titre d'exemple, cela permet notamment de prévoir, dans le capteur 400, une métasurface MS d'épaisseur moindre que dans le cas du capteur 100, la forme de la métasurface MS du capteur 400 pouvant en outre être adaptée à engendrer des sauts de phase et des phases au voisinage des coins de chaque partie MS(1) et MS(2) moindres par rapport au cas de la métasurface MS du capteur 100.

À titre de variante, la focalisation peut être réalisée majoritairement voire uniquement par les microlentilles 401, la métasurface MS étant alors par exemple dépourvue de fonction de focalisation. Cela permet de simplifier encore davantage la conception et la réalisation de la métasurface MS.

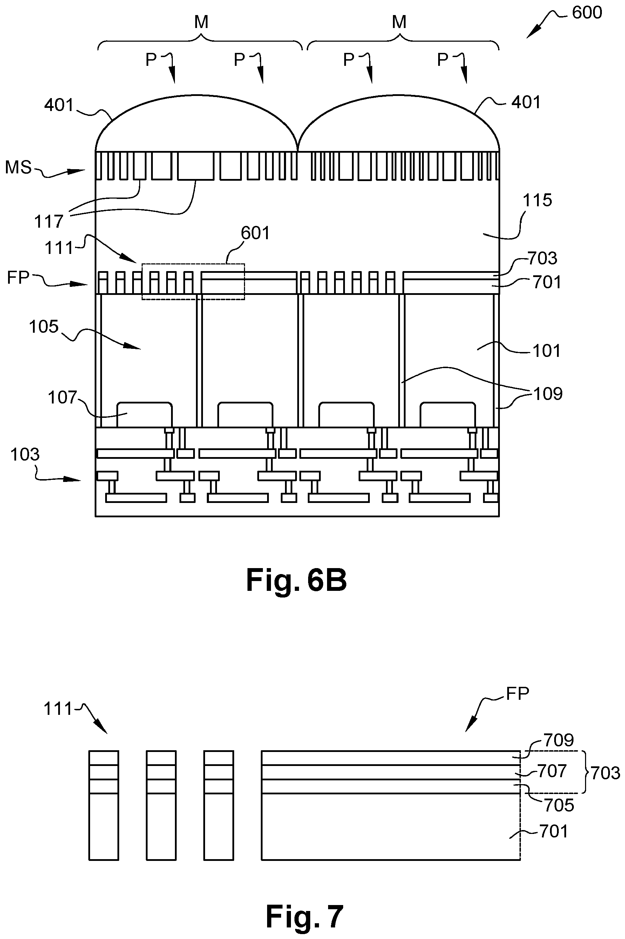

La figure 6A et la figure 6B sont respectivement une vue en perspective éclatée et une vue en coupe d'un autre exemple d'un capteur d'images polarimétrique 600 selon un mode de réalisation.

Le capteur d'images polarimétrique 600 des figures 6A et 6B comprend des éléments communs avec le capteur d'images polarimétrique 400 des figures 4A et 4B. Ces éléments communs ne seront pas détaillés à nouveau ci-après.

Le capteur 600 des figures 6A et 6B diffère du capteur 400 des figures 4A et 4B en ce que le capteur 600 comprend, outre les microlentilles 401 et la métasurface MS, un filtre polariseur FP interposé entre le substrat 101 et la métasurface MS. Le filtre polariseur FP du capteur 600 est par exemple analogue au filtre polariseur FP du capteur 100 précédemment décrit en relation avec les figures 1A et 1B.

La figure 7 est une vue en coupe, schématique et partielle, du filtre polariseur FP du capteur 600 des figures 6A et 6B. La figure 7 est plus particulièrement une vue de détail d'une partie du filtre polariseur FP délimitée par un encadré en pointillé 601 en figure 6B.

Selon un mode de réalisation, le filtre FP comprend, pour chaque pixel P, une structure de polarisation 111 comportant une pluralité de barres métalliques parallèles 701, chaque barre étant revêtue d'un empilement antireflet ou absorbant 703 comprenant, dans l'ordre depuis la face supérieure des barres 701 :

- une couche de tungstène 705 ;
- une couche de silicium 707, par exemple en silicium amorphe, revêtant la couche de tungstène 705 ; et
- une couche diélectrique 709, revêtant la couche de silicium 707.

À titre d'exemple, les barres métalliques 701 sont en tungstène ou en aluminium.

La couche 709 est par exemple une couche d'oxyde de silicium ou une couche de nitrure de silicium. À titre de variante, la couche 709 peut être constituée d'un empilement de plusieurs couches en des matériaux diélectriques d'indices de réfraction inférieurs à celui du silicium, par exemple une ou plusieurs couches d'oxyde de silicium et une ou plusieurs couches de nitrure de silicium.

Les épaisseurs des couches 705, 707 et 709 de l'empilement 703 sont choisies de façon à ce que l'empilement 703 présente, pour une longueur d'onde centrale $\lambda 0$ du photodétecteur 107, un coefficient d'absorption supérieur à celui du matériau 115. L'empilement 703 est dimensionné de sorte que, pour la longueur d'onde centrale $\lambda 0$ du photodétecteur 107 et pour un rayonnement incident sensiblement orthogonal au plan moyen de l'empilement 703, plus de 50 %, de préférence plus de 80 %, encore plus préférentiellement plus de 95 %, du rayonnement entrant dans l'empilement 703 soit absorbé dans l'empilement 703 en un seul passage. Autrement dit, plus de 50 %, de préférence plus de 80 %, encore plus préférentiellement plus de 95 %, d'un rayonnement entrant par la face supérieure de l'empilement 703 est absorbé dans l'empilement 703 et n'est pas réfléchi vers la région en le matériau 115. Par exemple, pour la longueur d'onde centrale $\lambda 0$, environ 90 % du rayonnement entrant dans l'empilement 703 est absorbé dans l'empilement 703 en un seul passage. Par exemple, plus de 50 %, préférentiellement plus de 80 %, encore plus préférentiellement plus de 90 % de tout rayonnement dans la plage de longueurs d'onde comprise entre 920 nm et 960 nm est absorbé en un seul passage dans l'empilement 703. De préférence, plus de 50 %, préférentiellement plus de 80 %, encore plus préférentiellement plus de 90 %, de tout rayonnement dans la bande passante du filtre FP est absorbé en un seul passage dans l'empilement 703.

Pour maximiser l'absorption dans l'empilement 703, l'épaisseur de la couche de tungstène 705 est de préférence relativement élevée, par exemple supérieure à 40 nm et de préférence supérieure à 60 nm dans un cas où les barres métalliques 701 sont en un matériau différent du tungstène. À titre de variante, dans le cas où les barres métalliques 701 sont en tungstène, les barres 701 et la couche 705 présentent par exemple une épaisseur cumulée supérieure à 40 nm et de préférence supérieure à 60 nm.

Des simulations numériques permettent d'ajuster l'épaisseur de silicium à prévoir pour maximiser l'absorption, en fonction des différents paramètres de l'empilement 703 et/ou de la longueur d'onde centrale $\lambda 0$. À titre d'exemple, l'épaisseur de la couche de silicium 705 est comprise entre 20 et 100 nm, de préférence entre 30 et 50 nm, par exemple égale à environ 39 nm.

Dans le filtre polariseur FP du capteur 600, la présence de la structure absorbante 703 permet avantageusement de réduire la détection des rayonnements parasites dans le proche infrarouge, et ainsi d'améliorer la qualité de l'image.

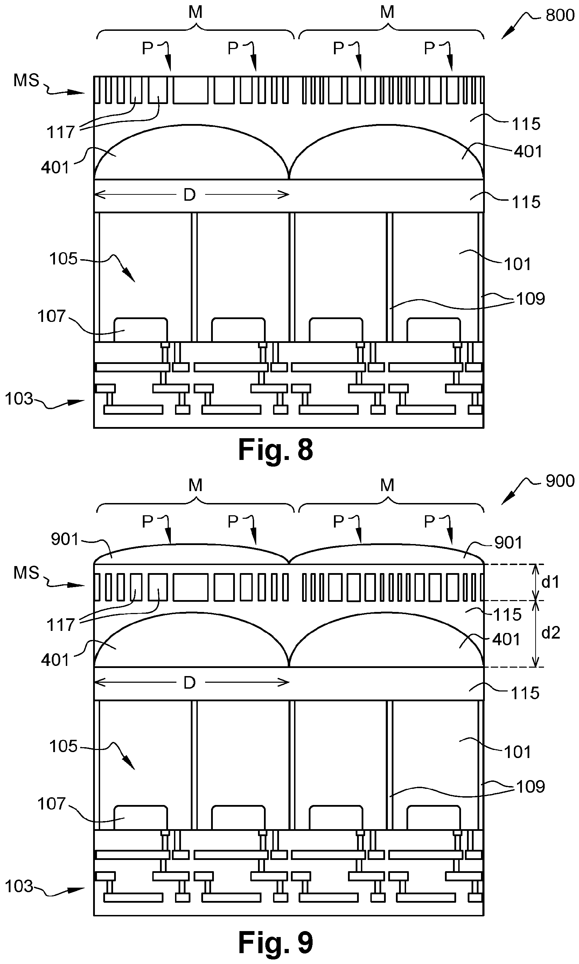

La figure 8 est une vue en coupe d'un autre exemple d'un capteur d'images polarimétrique 800 selon un mode de réalisation.

Le capteur d'images polarimétrique 800 de la figure 8 comprend des éléments communs avec le capteur d'images polarimétrique 400 des figures 4A et 4B. Ces éléments communs ne seront pas détaillés à nouveau ci-après.

Le capteur 800 de la figure 8 diffère du capteur 400 des figures 4A et 4B en ce que, dans le capteur 800, les microlentilles 401 sont interposées entre les photodétecteurs 107 des pixels P et la métasurface bidimensionnelle MS du routeur de polarisation.

Dans cet exemple, les microlentilles 401 sont situées dans la couche de planarisation 115. Les microlentilles 401 sont en un matériau présentant un indice optique supérieur à celui du matériau de la couche de planarisation 115. Dans le cas où la couche de planarisation 115 est en oxyde de silicium, les microlentilles 401 sont par exemple formées, par exemple par transfert de forme, dans une couche de nitrure de silicium ou de silicium amorphe.

Le fait de prévoir d'intercaler les microlentilles 401 entre la métasurface MS et les photodétecteurs 107 permet par exemple de faire en sorte que le rayonnement incident soit distribué à l'intérieur d'un cône défini par un objectif (non représenté) placé devant le capteur 100, plus précisément défini par une ouverture f/Dp de cet objectif, où f représente la focale et Dp le diamètre de la pupille d'entrée de l'objectif. Un avantage lié au fait d'intercaler les microlentilles 401 sous la métasurface MS est que cela permet de faire en sorte que les angles d'incidence liés au cône de distribution des rayonnements incidents soient plus faibles que ceux qui seraient produits, dans des conditions analogues, si les microlentilles 401 étaient disposées au-dessus de la métasurface MS. Cela permet avantageusement de faciliter la conception et la fabrication de la métasurface MS, la métasurface MS étant par exemple conçue et optimisée pour être utilisée sous un angle d'incidence donné, par exemple sous incidence normale, et présentant une acceptance angulaire inférieure à celle d'une optique réfractive « classique » telle qu'une lentille.

Le fait de disposer les microlentilles 401 entre la métasurface MS et les photodétecteurs 107 est néanmoins susceptible d'entraîner des phénomènes indésirables de diaphotie (« crosstalk optique », en anglais), c'est-à-dire qu'une partie du rayonnement incident à l'aplomb d'un macropixel M donné peut atteindre au moins l'un des macropixels voisins du macropixel considéré. Cela est en particulier le cas lorsque la métasurface MS présente un pouvoir de focalisation faible, voire inexistant (c'est-à-dire une distance focale très grande, voire infinie), les rayonnements incidents étant alors majoritairement, ou uniquement, déviés par la métasurface MS en fonction de leur polarisation. Le phénomène de diaphotie est d'autant plus présent que la déviation provoquée par la métasurface MS est importante et que la distance séparant la métasurface MS des microlentilles 401 est grande.

Afin de pallier cet inconvénient, la métasurface MS est par exemple conçue et réalisée de sorte à présenter une fonction de focalisation telle que les rayonnements déviés selon leur polarisation, par exemple les rayonnements déviés par la première partie MS(1) de la métasurface MS selon PS1 et PS2 pour les pixels P(1) et P(2) d'un macropixel M, atteignent uniquement la microlentille 401 sous-jacente. Chaque partie MS(1), MS(2) de la métasurface MS présente par exemple une distance focale f1 supérieure à la distance focale f2 de la microlentille 401 sous-jacente.

À titre d'exemple, la distance focale f1 de chaque partie MS(1), MS(2) de la métasurface MS est donnée par la formule suivante :

[Math 1]

$$f1 \leq \frac{D \times \tan\theta}{2}$$

Dans l'équation [Math 1] ci-dessus, $\theta$ représente l'angle de déflection d'une polarisation par la métasurface (la polarisation PS1 ou PS2, pour la partie MS(1) de la métasurface MS, ou la polarisation PS3 ou PS4, pour la partie MS(2) de la métasurface MS), et D représente la dimension latérale maximale de la microlentille 401 sous-jacente (par exemple le grand axe de la microlentille 401, dans le cas où la microlentille 401 présente une section ellipsoïdale).

L'angle de déflection $\theta$ correspond par exemple à un angle de déviation, par la métasurface MS, d'un rayonnement parvenant, sous incidence normale, au centre de la partie MS(1), respectivement MS(2), de la métasurface MS en fonction de la polarisation PS1 ou PS2, respectivement PS3 ou PS4, du rayonnement incident.

Une autre solution permettant d'éviter, ou d'atténuer, le phénomène de diaphotie est exposée ci-dessous en relation avec la figure 9.

La figure 9 est une vue en coupe d'un autre exemple d'un capteur d'images polarimétrique 900 selon un mode de réalisation.

Le capteur d'images polarimétrique 900 de la figure 9 comprend des éléments communs avec le capteur d'images polarimétrique 800 de la figure 8. Ces éléments communs ne seront pas détaillés à nouveau ci-après.

Le capteur 900 de la figure 9 diffère du capteur 800 de la figure 8 en ce que le capteur 900 comprend en outre, du côté du routeur de polarisation opposé aux photodétecteurs 107, une pluralité de microlentilles 901 distinctes des microlentilles 401. Les microlentilles 901 sont par exemple analogues aux microlentilles 401. Dans l'exemple représenté, chaque microlentille 901 présente une forme allongée et s'étendant en vis-à-vis d'une paire de pixels P adjacents du capteur 900, par exemple les pixels P(1) et P(2) ou les pixels P(3) et P(4) de l'un des macropixels M. Chaque microlentille 901 présente par exemple, en vue de dessus, une section de forme ovale ou rectangulaire à coins arrondis. Cet exemple n'est toutefois pas limitatif, les microlentilles 401 pouvant, à titre de variante, présenter une forme quelconque, par exemple circulaire ou carrée à coins arrondis, comme exposé précédemment. Dans l'exemple représenté, les microlentilles 901 sont des microlentilles réfractives.

À titre d'exemple, chaque microlentille 901 est réalisée en résine fluée.

Dans l'exemple représenté, les microlentilles 901 présentent une distance focale f3 supérieure à la distance focale f2 des microlentilles 401.

À titre d'exemple, la distance focale f3 de chaque microlentille 901 est donnée par l'équation suivante :

[Math 2]

$$f3 \leq \frac{D \times d1}{2 \tan \theta \times d2}$$

Dans l'équation [Math 2] ci-dessus :

- θ représente l'angle de déflection d'une polarisation par la métasurface (la polarisation PS1 ou PS2, pour la partie MS(1) de la métasurface MS, ou la polarisation PS3 ou PS4, pour la partie MS(2) de la métasurface MS) ;
- D représente la dimension latérale maximale de la microlentille 401 sous-jacente (par exemple le grand axe de la microlentille 401, dans le cas où la microlentille 401 présente une section ellipsoïdale) ;
- d1 représente la distance entre la face inférieure de la microlentille 901 et la face inférieure de la métasurface MS, dans l'orientation de la figure 9 ; et
- d2 représente la distance entre la face inférieure de la métasurface MS et la face inférieure de la microlentille 401, dans l'orientation de la figure 9.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. À partir des indications de la présente description, la personne du métier est en particulier capable de prévoir, dans les capteurs 100 et 400, un filtre polariseur présentant une structure analogue au filtre polariseur du capteur 600, c'est-à-dire comprenant une pluralité de barres métalliques parallèles revêtues d'un empilement absorbant.

En outre, bien que cela n'ait pas été représenté, les capteurs 800 et 900 précédemment exposés en relation avec les figures 8 et 9 peuvent comprendre un filtre polariseur interposé entre les photodétecteurs 107 et les microlentilles 401, par exemple un filtre polariseur identique ou analogue au filtre polariseur FP du capteur 600 ou au filtre polariseur FP du capteur 100.

Par ailleurs, les modes de réalisation décrits ne se limitent pas aux exemples de dimensions et de matériaux mentionnés dans la présente description pour la réalisation des métasurfaces.

Bien que l'on ait décrit ci-dessus des exemples de réalisation de capteurs à éclairement par la face arrière (BSI), les modes de réalisation décrits peuvent être adaptés à des capteurs à éclairement par la face avant (FSI, de l'anglais « Front Side Illumination »). Dans ce cas, la région photosensible de chaque pixel est éclairée à travers l'empilement d'interconnexion 103. Le filtre polariseur et/ou le routeur de polarisation sont alors formés du côté de la face avant (face inférieure dans l'orientation de la figure 1B) du substrat, avant la formation de l'empilement d'interconnexion 103.

Par ailleurs, dans le cas d'un capteur à éclairement par la face avant, les structures de polarisation 111 peuvent être formées dans un ou plusieurs niveaux métalliques de l'empilement d'interconnexion 103. Cela permet de ne pas introduire d'étape supplémentaire pour la fabrication des structures de polarisation 111.

En outre, les modes de réalisation décrits ne se limitent pas aux exemples présentés ci-dessus de réalisation de structures de polarisation 111 constituées de motifs métalliques, opaques, entourés latéralement d'un matériau diélectrique, transparent. À titre de variante, les structures de polarisation 111 peuvent être réalisées à base de matériaux transparents ou semi-transparents présentant un contraste d'indice, de manière à améliorer la transmission des polariseurs. Par exemple, pour des structures de polarisation destinées à fonctionner dans le proche infrarouge, par exemple à une longueur d'onde de l'ordre de 940 nm, on pourra utiliser des motifs en silicium, par exemple en silicium amorphe, entourés d'un matériau diélectrique de plus faible indice de réfraction, par exemple de l'oxyde de silicium. Pour des pixels destinés à mesurer des rayonnements visibles, on pourra utiliser des motifs en nitrure de silicium ou en oxyde de titane, entourés d'un matériau diélectrique de plus faible indice de réfraction, par exemple de l'oxyde de silicium.

On notera en outre que, dans un capteur à éclairement par la face arrière du type décrit en relation avec les figures 1A et 1B, en fonction de l'épaisseur du substrat 101 et de la longueur d'onde destinée à être mesurée par les pixels, une partie du rayonnement lumineux incident peut traverser toute l'épaisseur du substrat et se réfléchir sur des pistes métalliques de l'empilement d'interconnexion 103, avant d'être absorbé dans la région photosensible 105 des pixels.

La réflexion sur les pistes métalliques de l'empilement d'interconnexion peut conduire à polariser au moins partiellement la lumière selon une direction dépendant de l'orientation desdites pistes métalliques. De façon préférentielle, pour chaque pixel P du capteur, les pistes métalliques de l'empilement d'interconnexion 103 situées en vis-à-vis du pixel sont orientées selon une direction choisie en fonction de la polarisation du pixel, par exemple de façon à favoriser la polarisation de la lumière réfléchie selon l'orientation de polarisation destinée à être mesurée par le pixel. Ainsi, de façon préférentielle, les pistes métalliques de l'empilement d'interconnexion 103 situées en vis-à-vis de pixels destinés à mesurer des polarisations différentes, présentent des orientations différentes.

Par ailleurs, les modes de réalisation décrits ne se limitent pas aux exemples d'application décrits ci-dessus à des capteurs visibles. D'autres gammes de longueurs d'ondes peuvent tirer profit de pixels polarisants. Par exemple, les modes de réalisation décrits peuvent être adaptés à des capteurs infrarouges destinés à mesurer des rayonnements de longueur d'onde comprise entre 1 et 2 μm, par exemple à base d'InGaAs ou de germanium.

En outre, bien que l'on ait décrit ci-dessus des exemples dans lesquels les polarisations PS1 et PS2 sont orthogonales et les polarisations PS3 et PS4, tournées de 45° par rapport respectivement aux polarisations PS1 et PS2, sont orthogonales, la personne du métier est capable d'adapter les modes de réalisation de la présente description à des cas où les polarisations PS1 et PS2 ne sont pas orthogonales et/ou les polarisations PS3 et PS4 ne sont pas orthogonales, les polarisations PS3 et PS4 pouvant en outre être tournées d'un angle différent de 45° par rapport aux polarisations PS1 et PS2.

Enfin, la mise en oeuvre pratique des modes de réalisation et variantes décrits est à la portée de la personne du métier à partir des indications fonctionnelles données ci-dessus. En particulier, la personne du métier saura, à partir des indications de la présente description, concevoir, dimensionner et réaliser les métasurfaces et les filtres polariseurs et/ou les microlentilles des pixels du capteur, de façon que ces structures coopèrent pour obtenir l'effet recherché d'amélioration du compromis entre la sensibilité et le coefficient d'extinction de polarisation des pixels.

**Revendications**

1. Capteur d'images polarimétrique (400 ; 600 ; 800 ; 900) formé dans et sur un substrat semiconducteur (101), le capteur comprenant :

   - une pluralité de pixels (P) comprenant chacun un photodétecteur (107) formé dans le substrat semiconducteur ;
   - un routeur de polarisation comprenant une métasurface bidimensionnelle (MS) disposée du côté d'une face d'éclairement des photodétecteurs, la métasurface comprenant un réseau bidimensionnel de plots (117) ; et
   - une pluralité de premières microlentilles (401) s'étendant en vis-à-vis d'une paire de pixels (P(1), P(2)) adjacents du capteur,

   dans lequel chaque microlentille présente des dimensions latérales égales à celles d'un rectangle formé par ladite paire de pixels adjacents.

2. Capteur (400 ; 600 ; 800 ; 900) selon la revendication 1, dans lequel les premières microlentilles (401) présentent chacune une forme allongée.

3. Capteur (400 ; 600) selon la revendication 1 ou 2, dans lequel les premières microlentilles (401) sont disposées du côté du routeur de polarisation opposé aux photodétecteurs (107).

4. Capteur (800 ; 900) selon la revendication 1 ou 2, dans lequel les premières microlentilles (401) sont interposées entre les photodétecteurs (107) et la métasurface bidimensionnelle (MS).

5. Capteur (900) selon la revendication 4, comprenant en outre une pluralité de deuxièmes microlentilles (901) distinctes des premières microlentilles (401) et disposées du côté d'une face de la métasurface bidimensionnelle (MS) opposée aux photodétecteurs (107), chaque deuxième microlentille s'étendant en vis-à-vis d'une paire de pixels (P(1), P(2)) adjacents du capteur.

6. Capteur (900) selon la revendication 5, dans lequel chaque deuxième microlentille (901) présente une forme allongée.

7. Capteur (400 ; 600 ; 800 ; 900) selon l'une quelconque des revendications 1 à 6, dans lequel ladite pluralité de pixels (P) comprend, en vis-à-vis de l'une des premières microlentilles (401), des premier et deuxième pixels (P(1), P(2)) adaptés à mesurer des rayonnements selon respectivement des première et deuxième polarisations distinctes, une première partie (MS(1)) de la métasurface bidimensionnelle (MS) située à l'aplomb des premier et deuxième pixels étant adaptée à transmettre majoritairement :

   - des rayonnements selon la première polarisation vers le premier pixel (P(1)) ; et
   - des rayonnements selon la deuxième polarisation vers le deuxième pixel (P(2)).

8. Capteur (400 ; 600 ; 800 ; 900) selon la revendication 7, dans lequel les rangées de plots (117) de la première partie (MS(1)) de la métasurface bidimensionnelle (MS) sont identiques entre elles.

9. Capteur (400 ; 600 ; 800 ; 900) selon la revendication 7 ou 8, dans lequel la première partie (MS(1)) de la métasurface bidimensionnelle (MS) est adaptée à focaliser les rayonnements incidents majoritairement le long d'une direction (Ox) parallèle aux rangées de plots (117).

10. Capteur (400 ; 600 ; 800 ; 900) selon l'une quelconque des revendications 7 à 9, dans lequel les première et deuxième polarisations sont des polarisations linéaires selon des première et deuxième directions formant respectivement des angles de 0° et 90° par rapport à une direction de référence.

11. Capteur (400 ; 600 ; 800 ; 900) selon l'une quelconque des revendications 7 à 10, dans lequel ladite pluralité de pixels (P) comprend en outre des troisième et quatrième pixels (P(3), P(4)) adaptés à mesurer des rayonnements selon respectivement des troisième et quatrième polarisations distinctes, différentes des première et deuxième polarisations, une deuxième partie (MS(2)) de la métasurface bidimensionnelle (MS) située à l'aplomb des troisième et quatrième pixels étant adaptée à transmettre majoritairement :

- des rayonnements selon la troisième polarisation vers le troisième pixel (P(3)) ; et
- des rayonnements selon la quatrième polarisation vers le quatrième pixel (P(4)).

**12.** Capteur (400 ; 600 ; 800 ; 900) selon la revendication 11, dans lequel les troisième et quatrième polarisations sont des polarisations linéaires selon des troisième et quatrième directions formant respectivement des angles de 45° et 135° par rapport à la direction de référence.

**13.** Capteur (400 ; 600 ; 800 ; 900) selon l'une quelconque des revendications 1 à 12, dans lequel les plots (117) de la métasurface bidimensionnelle (MS) sont en silicium amorphe.

**14.** Capteur (400 ; 600 ; 800 ; 900) selon l'une quelconque des revendications 1 à 13, dans lequel les plots (117) de la métasurface bidimensionnelle (MS) sont entourés latéralement d'oxyde de silicium.

**15.** Capteur (400 ; 600 ; 800 ; 900) selon l'une quelconque des revendications 1 à 14, dans lequel les plots (117) de la métasurface bidimensionnelle (MS) présentent des dimensions latérales sub-longueur d'onde.

**16.** Capteur (600 ; 800 ; 900) selon l'une quelconque des revendications 1 à 15, comprenant en outre un filtre polariseur (FP) interposé entre ladite pluralité de pixels (P) et la métasurface bidimensionnelle (MS), le filtre comprenant, pour chaque pixel (P), une structure de polarisation (111).

**17.** Capteur (600 ; 800 ; 900) selon la revendication 16, dans sa dépendance à l'une quelconque des revendications 7 à 10, dans lequel la structure de polarisation (111) du premier pixel (P(1)) est adaptée à transmettre majoritairement des rayonnements selon la première polarisation et la structure de polarisation (111) du deuxième pixel (P(2)) est adaptée à transmettre majoritairement des rayonnements selon la deuxième polarisation.

**18.** Capteur (600 ; 800 ; 900) selon la revendication 16 ou 17, dans lequel chaque structure de polarisation (111) comprend une pluralité de barres parallèles métalliques (701) .

**19.** Capteur (600 ; 800 ; 900) selon la revendication 18, dans lequel chaque barre métallique (701) est revêtue d'un empilement absorbant (703).

**20.** Capteur (600 ; 800 ; 900) selon la revendication 19, dans lequel l'empilement absorbant (703) comprend :

- une couche de tungstène (705) ;
- une couche de silicium (707), revêtant la couche de tungstène ; et
- une couche diélectrique (709), revêtant la couche de silicium.

**Fig. 1A**

**Fig. 1B**

**Fig. 2**

**Fig. 3**

Fig. 4A

Fig. 4B

Fig. 5

Fig. 6A

**Fig. 6B**

**Fig. 7**

**Fig. 8**

**Fig. 9**

Europäisches
Patentamt

European
Patent Office

Office européen
des brevets

# RAPPORT DE RECHERCHE EUROPEENNE

Numéro de la demande

**EP 23 21 5994**

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | CN 217 386 086 U (TIANJIN SHANHE OPTOELECTRONICS TECH CO LTD) 6 septembre 2022 (2022-09-06) | 1-4,7-9, 13-19 | INV. G01J4/04 H01L27/146 |
| A | * alinéas [0006], [0053]; revendication 7; figure 4 * | 5,6,20 | |
| X | STOCK CARSTEN ET AL: "Fully integrated stokes snapshot imaging polarimeter", EPJ WEB OF CONFERENCES , vol. 238 1 janvier 2020 (2020-01-01), page 06018, XP055828443, DOI: 10.1051/epjconf/202023806018 Extrait de l'Internet: URL:https://www.epj-conferences.org/articles/epjconf/pdf/2020/14/epjconf_eosam2020_06018.pdf | 1-4,7-19 | |
| A | * section 2: "setup and fabrication of the nano-optical elements"; figure 1 * | 5,6,20 | |
| A | XIE TING ET AL: "Infrared multispectral imaging system based on metasurfaces for two infrared atmospheric windows", PROCEEDINGS OF THE SPIE, SPIE, US, vol. 12072, 13 décembre 2021 (2021-12-13), pages 1207208-1207208, XP060151292, ISSN: 0277-786X, DOI: 10.1117/12.2604345 ISBN: 978-1-5106-5738-0 * figure 1a * | 1-20 | **DOMAINES TECHNIQUES RECHERCHES (IPC)** G01J H01L |

Le présent rapport a été établi pour toutes les revendications

| Lieu de la recherche | Date d'achèvement de la recherche | Examinateur |
|---|---|---|
| Munich | 16 avril 2024 | Haan, Martine |

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 23 21 5994

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

16-04-2024

| Document brevet cité au rapport de recherche | Date de publication | Membre(s) de la famille de brevet(s) | Date de publication |
|---|---|---|---|
| CN 217386086 U | 06-09-2022 | CN 217386086 U | 06-09-2022 |
| | | US 2023387162 A1 | 30-11-2023 |

EPO FORM P0460

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **DE ZHU, R. ; QIU, T. ; WANG, J et al.** Phase-to-pattern inverse design paradigm for fast realization of functional metasurfaces via transfer learning. *Nat. Commun,* 2021, vol. 12, 2974

- **DE RUBIN et al.** Matrix Fourier optics enables a compact full-Stokes polarization caméra. *SCIENCE,* 05 Juillet 2019, vol. 365 (6448